# EUROPÄISCHE PATENTSCHRIFT

(11) **EP 2 785 558 B1**
(45) Veröffentlichungstag und Bekanntmachung des Hinweises auf die Patenterteilung: **09.01.2019**
(21) Anmeldenummer: 12816010.8
(22) Anmeldetag: 30.11.2012
(51) Int. Cl.: B60L 11/18, B60L 3/00, B60R 16/033, G01R 31/00, H02J 7/00, G01R 31/36

(54) **VORRICHTUNG ZUR ERFASSUNG DES ZUSTANDS EINES ZU PRÜFENDEN AKKUMULATORS**
APPARATUS FOR DETECTING THE STATE OF A STORAGE BATTERY
DISPOSITIF POUR DÉTECTER L'ÉTAT D'UN ACCUMULATEUR

(30) Priorität: 02.12.2011 DE 102011087678
(43) Veröffentlichungstag der Anmeldung: 08.10.2014
(73) Patentinhaber: Conti Temic Microelectronic GmbH, 90411 Nürnberg (DE)
(72) Erfinder: EHRMANN, Martin, 90480 Nürnberg (DE); MAISEL, Peter, 90443 Nürnberg (DE)
(74) Vertreter: Bonn, Roman Klemens
(86) Internationale Anmeldenummer: PCT/EP2012/074035
(87) Internationale Veröffentlichungsnummer: WO 2013/079636

(56) Entgegenhaltungen:
- DE-A1-102004 035 470
- US-A1- 2005 280 396
- US-A1- 2008 024 137
- US-A1- 2009 015 193

## Beschreibung

Es wird eine Vorrichtung zur Erfassung des Zustands eines zu prüfenden Akkumulators eines Fahrzeugs mit mindestens zwei Fahrzeugbordnetzen unterschiedlicher Betriebsspannungen beschrieben. Die Fahrzeugbordnetze sind über einen DC/DC-Wandler, der eine erste Gleichspannung eines ersten Fahrzeugbordnetzes in eine zweite Gleichspannung des Akkumulators des zweiten Fahrzeugbordnetzes wandelt, gekoppelt. Die Fahrzeugbordnetze weisen eine Steuereinrichtung auf.

Aus der Druckschrift US 7,889,524 B2 ist dazu ein integrierter bidirektionaler Wandler für Hybrid-Fahrzeuge mit elektrischer Aufladung bekannt, der eine einzige Induktionsspule als induktiven Speicher aufweist und über einen AC/DC Wandler eine elektrische Auflade-Funktion ermöglicht. Weiterhin kann in einer sogenannten Boost-Funktion durch den bidirektionalen DC/DC Wandler Leistung eines Akkumulators an ein erstes Fahrzeugnetz mit höherer Betriebsspannung als der Akkumulator geliefert werden und umgekehrt in einer so genannten Buck-Funktion kann Leistung aus dem ersten Fahrzeugnetz an den Akkumulator in einem zweiten Fahrzeugnetz mit der Betriebsspannung des Akkumulators abgegeben werden. Dazu weisen die über den DC/DC Wandler gekoppelten Fahrzeugbordnetze eine Steuereinrichtung auf.

Der Zustand eines Akkumulators in derartigen Fahrzeugbordnetzen wird jedoch in dem Fahrzeug weder angezeigt noch geprüft.

In der Druckschrift DE 10 2004 035 470 A1 wird beschrieben, zur Erfassung des Ladezustands eine Leerlaufspannung zu erfassen, nachdem ein Strompuls beendet ist, der von einem Gleichstromwandler erzeugt wird. Der Gleichstromwandler wird als Ladesteuerungssystem für zwei in Reihe geschalteten Batterien verwendet.

Bei herkömmlichen Fahrzeugen mit 12 V-Bordnetz und Verbrennungsmotor findet ein Test eines 12 V-Akkumulators implizit bei jedem Anlassvorgang des Verbrennungsmotors statt. Dabei wird aus dem Akkumulator während des

Startvorgangs ein hoher Strom gezogen. Ist der Startvorgang dann möglich, so ist damit eine Prüfung des Mindestladezustands, auch genannt SOC-Zustands (State of Charge), und des Alterungszustands, auch bezeichnet als SOH-Zustand (State of Health), verbunden. Falls der Startvorgang nicht möglich ist, kann entweder der Mindest-SOC-Zustand oder der Mindest-SOH-Zustand des Akkumulators nicht gegeben sein, so dass das Fahrzeug nicht in Gang gesetzt werden kann.

Damit kann es bei herkömmlichen Fahrzeugen auch nicht zu einem Sicherheitsrisiko durch eine unzureichend funktionierende Batterie kommen. Jedoch bei Hybridfahrzeugen oder Elektrofahrzeugen, die üblicherweise Fahrzeugbordnetze mit unterschiedlichen Betriebsspannungen aufweisen, wie einer Hochvoltseite und einer Niedervoltseite, und die keinen Starter auf der Niedervoltseite aufweisen, entfällt dieser Startvorgangstest und damit der herkömmliche Test auf der Niedervoltseite.

Da jedoch für den sicheren Betrieb auch dieser Fahrzeuge ein Mindest-SOC-Zustand und ein Mindest-SOH-Zustand des Niedervoltakkumulators erforderlich ist, muss auch in diesen Fahrzeugen wiederkehrend eine entsprechende Prüfung erfolgen. Diese Prüfung des Akkumulators erfolgt mithilfe fahrzeug-externer Prüfgeräte in entsprechend vorgeschriebenen Wartungsintervallen. Werden diese jedoch vom Fahrzeughalter nicht eingehalten, so stellen derartige Fahrzeuge ein Sicherheitsrisiko dar, das nur durch rechtzeitige Warnung des Fahrzeugführers vermindert werden kann.

Eine Aufgabe der Erfindung ist es, eine Vorrichtung zur Erfassung des Zustands eines zu prüfenden Akkumulators anzugeben, die eine ständige Überwachung und Anzeige des Zustands eines Fahrzeugakkumulators unabhängig von Wartungs- und Prüfungsintervallen ermöglicht.

Gelöst wird diese Aufgabe mit dem Gegenstand der unabhängigen Ansprüche. Vorteilhafte Weiterbildungen der Erfindung ergeben sich aus den abhängigen Ansprüchen.

In einer Ausführungsform der Erfindung wird eine Vorrichtung zur Erfassung des Zustands eines zu prüfenden Akkumulators eines Fahrzeugs mit mindestens zwei Fahrzeugbordnetzen unterschiedlicher Betriebsspannungen geschaffen. Die Fahrzeugbordnetze sind über einen DC/DC-Wandler, der eine erste Gleichspannung eines ersten Fahrzeugbordnetzes in eine zweite Gleichspannung des Akkumulators des zweiten Fahrzeugbordnetzes wandelt, gekoppelt. Die Bordnetze weisen eine Steuereinrichtung auf. Die Steuereinrichtung weist ein Testsignalmodul, das geeignet ist, ein Testsignal über den DC/DC-Wandler an den zu prüfenden Akkumulator anzulegen, auf. Außerdem umfasst die Steuereinrichtung zusätzlich ein Messwerterfassungsmodul, das geeignet ist, die Reaktionswerte des zu prüfenden Akkumulators zu messen und ein Auswertemodul, das geeignet ist, aus den gemessenen Reaktionswerten den Zustand des Akkumulators zu erfassen.

Mehrere der funktionalen Einheiten, die in dieser Spezifikation beschrieben werden, werden als Module bezeichnet, um besonders ihre Ausführungsunabhängigkeit hervorzuheben. In diesem Zusammenhang können Module Hardware-Schaltkreise mit einem oder mehreren Prozessoren mit Speicher, Höchst-Integrations-Schaltkreise (VLSI), Gate Arrays, programmierbare Logik- und/oder diskrete Komponenten einschließen. Die Hardware-Schaltungen können Logikfunktionen durchführen, computerlesbare Programme, die auf fassbaren Speichergeräten gespeichert sind, durchführen und/oder programmierte Funktionen ausführen. Module können auch ein computerlesbares Speichermedium einschließen, das ein computerlesbares Programm umfasst, welches auf einem fassbaren Speichergerät gespeichert ist, das eine Funktion durchführt, wenn es durch eine Hardware-Schaltung wie einem Prozessor, Mikroprozessor oder dergleichen ausgeführt wird.

Ein Vorteil einer derartigen Vorrichtung liegt einerseits darin, dass für diese Vorrichtung Komponenten, wie beispielsweise der DC/DC-Wandler, bereits in derartigen Fahrzeugen wie Hybrid- oder Elektrofahrzeugen vorhanden sind und für eine Diagnose einer zu prüfenden Batterie praktisch zur Verfügung stehen, einschließlich der Möglichkeit neben dem Ladezustand auch den Alterungszustand frühzeitig zu erkennen und damit einen Hinweis auf einen rechtzeitigen Austausch des Akkumulators geben zu können, bevor ein Liegenbleiben des Fahrzeugs die Sicherheit desselben und der Insassen gefährdet.

Mit der erfindungsgemäßen Vorrichtung zur Erfassung des Zustands eines zu prüfenden Akkumulators ist der Vorteil verbunden, dass der Akkumulator über die Steuereinrichtung der Fahrzeugbordnetze fortlaufend geprüft werden kann und der Fahrzeughalter nicht mehr von den Wartungsintervallen oder Instandsetzungsintervallen der Herstellerfirma abhängig ist. Ferner ist der Fahrzeughalter nicht mehr auf separate Batterietestvorrichtungen, wie sie in den Werkstätten zur Verfügung stehen, angewiesen. Vielmehr kann er fortlaufend mithilfe des Anzeigemoduls verfolgen, wie sich der Ladezustand des Akkumulators entwickelt, ob die Ladekapazität des Akkumulators im Laufe der Zeit abnimmt und einen kritischen SOH-Zustand unterschreitet, so dass ein zuverlässiger Betrieb des Fahrzeugs nicht mehr gesichert ist.

In einer Ausführungsform der Erfindung weist das Testsignalmodul ein Spannungssprunggebermodul auf und das Messgeräterfassungsmodul ein Strommessermodul, das den zeitlichen Verlauf des Stromes als Reaktion des Akkumulators erfasst. Ein derartiger Spannungssprung eines Spannungssprunggebermoduls kann sowohl in einer Ladespannungserhöhung als auch in einer Ladespannungsabsenkung bestehen, wobei im ersteren Fall der Ladestrom des Akkumulators deutlich zunehmen muss und im letzteren Fall der Ladestrom des Akkumulators verringert wird.

Weiterhin ist es auch möglich, dass das Testsignalmodul ein Stromsprunggebermodul aufweist und das Messwerterfassungsmodul ein Spannungsmessermodul besitzt. Das Spannungsmessermodul kann den zeitlichen Verlauf der Spannung als Reaktion des Akkumulators erfassen. Dabei ist entscheidend, wie schnell sich die Akkumulatorspannung von dem Stromsprung erholt, wenn es sich bei dem Testsignal um einen Entnahmestromsprung handelt.

Weiterhin ist es vorgesehen, dass das Testsignalmodul ein Spannungsimpulsgebermodul aufweist und das Messwerterfassungsmodul ein Strommessermodul umfasst, das den zeitlichen Verlauf des Stromes als Reaktion des Akkumulators erfasst. Bei einem derartigen Testsignal in Form eines Spannungsimpulses kommt es darauf an, ob der Spannungsimpuls die Ladespannung des Akkumulators erhöht oder für die Zeit des Testimpulses vermindert. Je deutlicher und schneller der Akkumulator auf eine derartige Änderung der Ladespannung reagiert, umso sicherer kann davon ausgegangen werden, dass der Akkumulator voll funktionsfähig ist. Erst, wenn Anomalien in der Reaktion des Akkumulators feststellbar sind, kann von einem Defekt des Akkumulators ausgegangen werden.

In einer weiteren Ausführungsform der Erfindung weist das Testsignalmodul ein Stromimpulsgebermodul auf und das Messwerterfassungsmodul ein Spannungsmessermodul. Das Spannungsmessermodul erfasst den zeitlichen Verlauf der Spannung als Reaktion des Akkumulators. Bei einem derartigen Test wird kurzzeitig für die Impulsdauer ein Entladestrom dem Akkumulator aufgeprägt und beobachtet, wie schnell sich die Batterie von dem Stromimpuls erholt. Dabei entsteht in dem Gesamtsystem der Fahrzeugnetzwerke kein hoher Energieverlust, da ein derartiger Test mithilfe des bidirektionalen DC/DC-Wandlers durchgeführt wird und die Testenergie in dem gemeinsamen induktiven Speicher zwischengespeichert wird, so dass nur ein geringer Anteil einen Testenergieverlust darstellt.

Schließlich ist es auch möglich, das Testsignalmodul mit einem Wechselspannungsgebermodul auszustatten und das Messwerterfassungsmodul als Strommessermodul auszubilden, so dass mit dem Strommessermodul der Verlauf des Stroms als Reaktion des Akkumulators auf die angelegte Wechselspannung erfasst werden kann. Mit Testsignalen eines Wechselspannungsgebermoduls kann der Innenwiderstand eines Akkumulators überprüft werden, der einen Hinweis darauf liefert, ob beispielsweise ein Bleiakkumulator einen ausreichenden Flüssigkeitsstand aufweist, da mit abnehmendem Flüssigkeitsstand der Innenwiderstand eines Bleiakkumulators steigt.

Alternativ kann das Testsignalmodul ein Wechselstromgebermodul aufweisen und das Messwerterfassungsmodul ein Spannungsmessermodul besitzen. Das Spannungsmessermodul erfasst den zeitlichen Verlauf der Spannung als Reaktion des Akkumulators auf den eingeprägten Wechselstrom. Auch bei dieser Ausführungsform der Vorrichtung kann auf den Innenwiderstand der Batterie geschlossen werden und bei Veränderung des Innenwiderstands der Batterie auf beispielsweise den Flüssigkeitszustand eines Bleiakkumulators geschlossen werden.

Weiterhin ist es vorgesehen, dass das Auswertemodul mit einem Anzeigemodul zusammenwirkt, wobei das Anzeigemodul eine optische Anzeige für einen Ladezustand anzeigt. Somit kann der Fahrer eines Fahrzeugs immer erkennen, ob der Akkumulator ein Sicherheitsrisiko darstellt oder ob der Ladezustand des Akkumulators ausreichend ist, um den Betrieb des Fahrzeugs zu gewährleisten.

Weiterhin ist es vorgesehen, dass das Auswertemodul mit einem Anzeigemodul zusammenwirkt, wobei das Anzeigemodul eine optische Anzeige für den Alterungszustand aufweist. Bevor der SOH-Zustand unter den zulässigen mindest SOH-Zustand abgefallen ist, empfiehlt es sich, den Akkumulator extern zu prüfen und gegebenenfalls auszutauschen.

In diesem Zusammenhang ist es von Vorteil, wenn die Vorrichtung ein Warnmodul aufweist, das mittels des optischen und/oder eines akustischen Anzeigemoduls bei einem kritischen Ladezustand und/oder einem kritischen SOH-Zustand ein Warnzeichen und/oder ein Warnsignal generiert.

In einer weiteren Ausführungsform der Erfindung ist es vorgesehen, dass der zu prüfende Akkumulator einen Bleiakkumulator in einem der mindestens zwei Fahrzeugbordnetze aufweist. Bei einem Bleiakkumulator ist dieser Test deshalb entscheidend, weil üblicherweise für Hybridfahrzeuge der vorhandene Elektromotor eingesetzt wird, um den Verbrennungsmotor des Fahrzeugs, bei Elektrofahrzeugen existiert kein Anlassvorgang, anzulassen. Damit entfällt der herkömmliche automatische Test in Bezug auf den SOC-Zustand und auf den SOH-Zustand des Bleiakkumulators beim Anlassen des Fahrzeugs.

In einer weiteren Ausführungsform der Erfindung weist das erste Fahrzeugbordnetz eine höhere Gleichspannung auf als das zweite Fahrzeugbordnetz, wobei das erste Fahrzeugbordnetz einen Litiumionenakkumulator aufweisen kann. Ein derartiger Litiumionenakkumulator besteht aus einer Vielzahl von Einzelzellen, die jedoch in der Summe eine hohe Betriebsspannung zur Verfügung stellen können, die bis zu einigen 100 Volt aufweisen kann. Jedoch ist für Fahrzeuge als hohe Betriebsspannung eine Spannung vorgesehen, die unterhalb der Gefährdungsspannung für Personen liegt und damit den Wert von 100 V nicht überschreitet. Andernfalls sind besondere Sicherheitsabschirmungen und Sicherheitsschaltungen vorzusehen, um sicherzustellen, dass selbst bei Unfällen keine Gefahr von dem Hochspannungsvoltnetz ausgehen kann.

Weiterhin ist es vorgesehen, dass das erste Fahrzeugbordnetz mit hoher Betriebsspannung einen AC/DC-Wandler aufweist, der eine dreiphasige Generatorwechselspannung eines dreiphasigen Wechselstromgenerators in eine Ladegleichspannung beispielsweise eines Hochvolt-Litiumionenakkumulators wandelt. Über den oben erwähnten DC/DC-Wandler sind die beiden Fahrzeugnetzwerke mit hoher Betriebsspannung bzw. mit niedriger Betriebsspannung miteinander gekoppelt.

Dabei ist der DC/DC-Wandler als ein bidirektionaler DC/DC Wandler ausgebildet und formt beispielsweise eine Ladegleichspannung des Litiumionenakkumulators in eine niedrigere Ladespannung eines Bleiakkumulators um, wobei die Energie für die Testsignale größtenteils über eine gemeinsame induktive Speichereinheit des bidirektionalen DC/DC-Wandlers zurück gewonnen wird.

Das Testsignalmodul ist derart ausgelegt, dass es geeignet ist, über den DC/DC-Wandler an den Bleiakkumulator ein Testsignal anzulegen, der mit einem Messwerterfassungsmodul zusammenwirkt, das geeignet ist, die Reaktionswerte des Bleiakkumulators zu messen und an ein Auswertemodul weiterzugeben. Das Auswertemodul seinerseits wurde bereits eingehend besprochen und kann folglich aus den gemessenen Reaktionswerten den Zustand des Bleiakkumulators erfassen und separat oder über ein der Steuereinrichtung zugeordnetes zentrales Anzeigemodul den Ladezustand oder auch den SOH-Zustand des Bleiakkumulators anzeigen.

Ausführungsformen der Erfindung werden nun anhand der beigefügten Figuren näher erläutert.
- Figur 1: zeigt ein schematisches Blockschaltbild einer ersten Ausführungsform der Erfindung;
- Figur 2: zeigt ein erweitertes schematisches Blockschaltbild der Ausführungsform gemäß Figur 1;
- Figur 3: zeigt ein schematisches Blockschaltbild gemäß einer zweiten Ausführungsform der Erfindung.

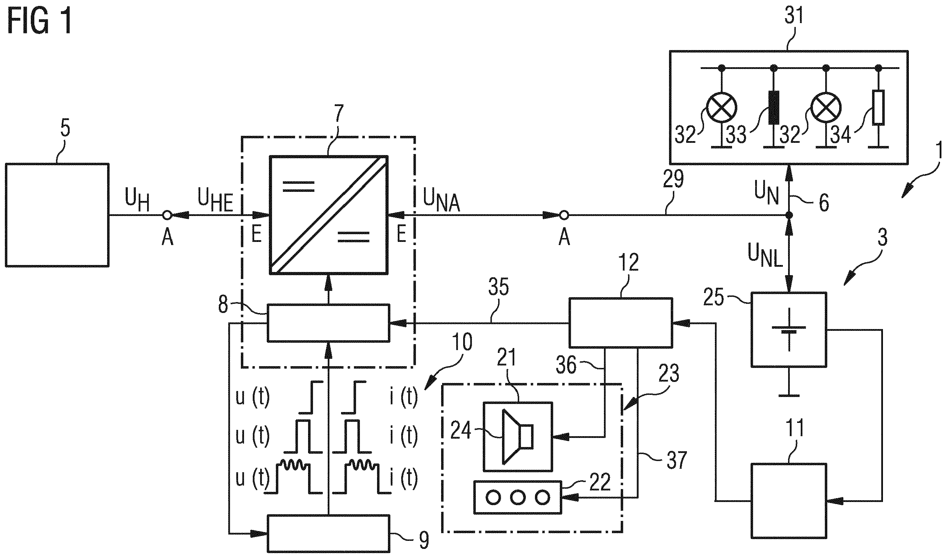

Das Blockschaltbild gemäß Figur 1 zeigt eine Vorrichtung 1 gemäß einer ersten Ausführungsform der Erfindung. In dem Blockschaltbild wird ein erstes Fahrzeugbordnetz 5 mit hoher Betriebsspannung U_{H} über einen DC/DC-Wandler 7 mit einem zweiten Fahrzeugbordnetz 6 gekoppelt. Dazu liegt auf der Hochspannungsseite des DC/DC-Wandlers 7 eine hohe Eingangsspannung U_{HE} beim Energietransfer in Pfeilrichtung E an und auf der Niederspannungsseite weist der DC/DC-Wandler 7 eine niedrigere Ausgangsspannung U_{NA} in der Größenordnung der zweiten Betriebsspannung U_{H} für das zweite Betriebsnetz 6 auf.

Dieser DC/DC-Wandler 7 ist als bidirektionaler Wandler ausgelegt, so dass der Eingang und der Ausgang für einen Energietransfer auch getauscht werden können, das heißt, dass die Hochspannungsseite von der Niederspannungsseite gespeist wird und umgekehrt die Niederspannungsseite von der Hochspannungsseite gespeist wird. Dieses ist durch den Einsatz eines gemeinsamen induktiven Speichers des DC/DC-Wandlers 7 möglich und wird in Figur 1 durch die Pfeilrichtungen E und A symbolisiert, wobei E für Eingang und A für Ausgang steht.

An einer BUS-Leitung 29 des zweiten Fahrzeugbordnetzes 6 mit entsprechend niedriger Betriebsspannung U_{N} sind nicht nur Verbraucher 31 wie Beleuchtungskörper 32, induktiv wirkende Wicklungen 33 oder Heizwiderstände 34 einer elektrischen Heizung sondern auch ein Akkumulator 3 angeschlossen. Um den Ladezustand und den SOH-Zustand des Akkumulators 3 laufend während des Betriebs des Fahrzeugs zu überprüfen, ist mindestens in dem Fahrzeugbordnetz 6 eine Steuereinrichtung 8 angeordnet, die mit dem DC/DC-Wandler 7 zusammenwirkt.

Dem DC/DC-Wandler 7 wird ein Testsignal 10 eines Testsignalmoduls 9 zugeführt, das der Prüfung des Zustands des Akkumulators 3 dient. An den Akkumulator 3 ist ein Messwerterfassungsmodul 11 angeschlossen, das den zeitlichen Verlauf einer Reaktion auf das Testsignal 10 erfasst und diesen Wert einem Auswertemodul 12 zuführt.

Das Auswertemodul 12 ist einerseits über eine Verbindungsleitung 35 mit der Steuereinrichtung 8 verbunden und über die Leitungen 36 und 37 mit einem Anzeigemodul 21 gekoppelt. Das Anzeigemodul 21 weist einerseits eine optische Anzeige 22 und eine akustische Anzeige 24 auf und kann auch als Warnmodul 23 eingesetzt werden, wenn kritische Werte des Ladezustands des Akkumulators 3 oder kritische Werte der Ladekapazität des Akkumulators 3 unterschritten werden. Somit hat der Führer des Fahrzeugs jederzeit eine Anzeige, ob die Funktion bzw. der Zustand des Akkumulators 3 im grünen Bereich liegt, das heißt in einem sicheren Betriebszustand ist.

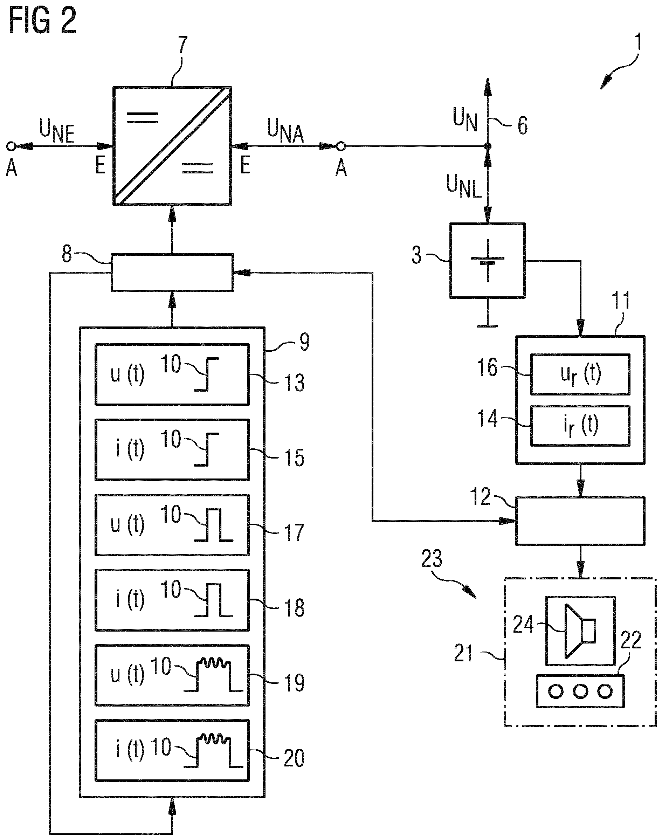

Figur 2 zeigt ein erweitertes schematisches Blockschaltbild der Ausführungsform gemäß Figur 1. Komponenten mit gleichen Funktionen wie in Figur 1 werden mit gleichen Bezugszeichen gekennzeichnet und in den nachfolgenden Figuren nicht extra erörtert.

Mit Figur 2 wird nun im Detail dargestellt, welche Module einerseits in dem Testsignalmodul 9 ein Testsignal erzeugen oder abgeben können und welche Module in dem Messwerterfassungsmodul 11 den zeitlichen Verlauf der Reaktion des Akkumulators 3 erfassen. Dazu kann das Testsignalmodul 9 ein Spannungssprunggebermodul 13 aufweisen, das mit u(t) einen Spannungssprung auf den Akkumulator 3 über die Steuereinrichtung 8 und den DC/DC-Wandler 7 ausüben kann. Alternativ kann das Testsignalmodul 9 ein Stromsprunggebermodul 15 aufweisen, das mit i(t) einen Stromsprung auf den Akkumulator 3 über die Steuereinrichtung 8 und den DC/DC-Wandler 7 ausüben kann.

Weiterhin kann das Testsignalmodul 9 ein Spannungsimpulsgebermodul 17 aufweisen, das einen Spannungsimpuls mit u(t) auf den Akkumulator 3 über die Steuereinrichtung 8 und den DC/DC-Wandler 7 ausüben kann. Alternativ kann das Testsignalmodul 9 ein Stromimpulsgebermodul 18 aufweisen, das einen Stromimpuls mit i(t) auf den Akkumulator 3 über die Steuereinrichtung 8 und den DC/DC-Wandler 7 einwirken lassen kann.

Schließlich ist es auch möglich, dass das Testsignalmodul 9 ein Wechselspannungsgebermodul 19 aufweist, das eine Wechselspannung mit u(t) auf den Akkumulator 3 über die Steuereinrichtung 8 und den DC/DC-Wandler 7 ausüben kann. Alternativ kann das Testsignalmodul 9 ein Wechselstromgebermodul 20 aufweisen, das einen Wechselstrom i(t) auf den Akkumulator 3 über die Steuereinrichtung 8 und den DC/DC-Wandler 7 einwirken lassen kann.

Der zeitliche Verlauf der Reaktion des zu prüfenden Akkumulators 3 wird durch das Messwerterfassungsmodul 11 gemessen mithilfe eines Spannungsmessermoduls 16, das die Reaktionsspannung uᵣ(t) erfasst, oder mithilfe eines Strommessermodul 14, das den Reaktionsstrom iᵣ(t) erfasst. Wie bereits mit Figur 1 erklärt, werden die gemessenen und erfassten Werte einem Auswertemodul 12 zugeführt, das seinerseits mit einem Anzeigemodul 21 zusammenwirkt und optische Anzeigen 22 und akustische Anzeigen 24 aufweist.

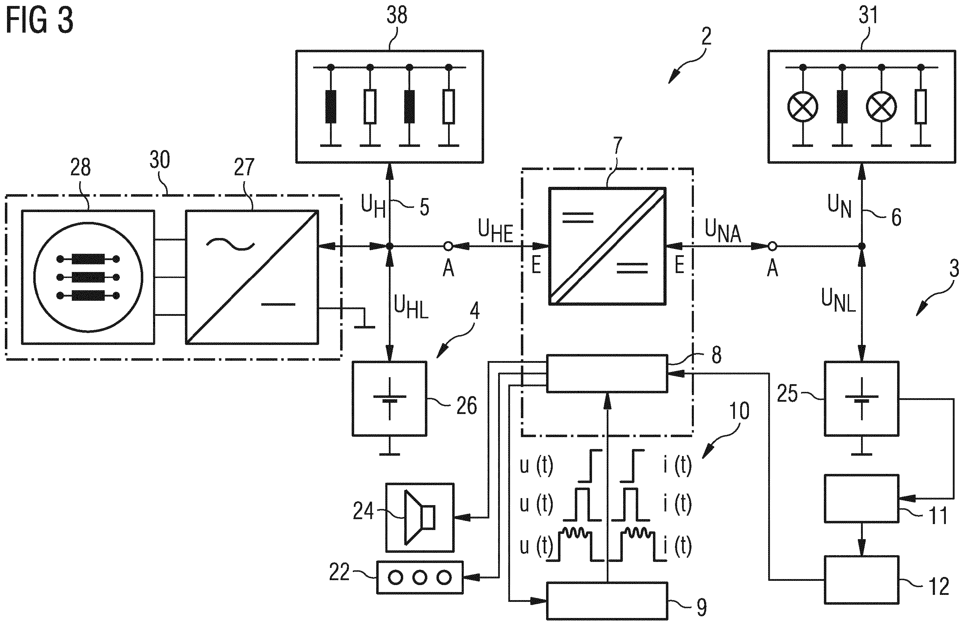

Figur 3 zeigt ein schematisches Blockschaltbild einer Vorrichtung 2 gemäß einer zweiten Ausführungsform der Erfindung. Die zweite Ausführungsform der Erfindung umfasst die Details der ersten Ausführungsform der Erfindung, wie sie bereits in Figur 1 und 2 gezeigt werden, und zeigt Komponenten des ersten Fahrzeugbordnetzes 5 mit hoher Betriebsspannung U_{H}. Die Verbraucher 38 des ersten Fahrzeugbordnetzes 5 unterscheiden sich lediglich in der Anschlussspannung bzw. der Betriebsspannung, bei der die Verbraucher 38 betrieben werden können, von den Verbrauchern 31 im zweiten Fahrzeugbordnetz 6.

Das erste Fahrzeugbordnetz 5 erhält seine Leistung von einem dreiphasigen Wechselstromgenerator 28, der mit einem AC/DC-Wandler 27 in einer Aufladevorrichtung 30 zusammenwirkt. Diese Aufladevorrichtung 30 kann bei einem Hybridfahrzeug den fahrzeugeigenen Generator umfassen, der durch Umschalten auch als Elektromotorantrieb eingesetzt werden kann, oder diese Aufladevorrichtung 30 kann unmittelbar mit einem dreiphasigen Netzanschluss an ein Versorgungsnetz angeschlossen werden, und damit letztendlich auch mit einem dreiphasiger Wechselspannungsgenerator 28 zusammenwirken, der die Leistung für eine Aufladevorrichtung 30 zur Verfügung stellt. Mit dieser Aufladevorrichtung 30 wird ein erster Akkumulator 4 mit einer Ladespannung U_{HL} aufgeladen, wobei dieser erste Akkumulator 4 in dieser Ausführungsform der Erfindung ein Litiumionenakkumulator 26 ist.

Aufgrund der bidirektionalen Wirkung des DC/DC-Wandlers 7, der die beiden Fahrzeugnetzwerke 5 und 6 koppelt, kann der Litiumionenakkumulator 26 des ersten Fahrzeugleitungsnetzes 5 auch den zu prüfenden Bleiakkumulator 25 des zweiten Fahrzeugbordnetzes 6 mit einer niedrigen Ladespannung U_{NL} aufladen. Umgekehrt kann der Akkumulator 3 über den DC/DC-Wandler 7 auch den Litiumionenakkumulator 26 aufladen. Durch die bidirektionale Kopplung der beiden Netzwerke 5 und 6 über den DC/DC-Wandler geht die Energie, die für die Testsignalerzeugung erforderlich ist, nicht verloren, sondern wird über ein nicht gezeigtes induktives Speicherelement des DC/DC-Wandlers 7 zwischengespeichert, so dass nur ein geringer Anteil der für die Erzeugung des Testsignals erforderlichen Energie verloren geht.

### Bezugszeichenliste

- 1: Vorrichtung (1. Ausführungsform)
- 2: Vorrichtung (2. Ausführungsform)
- 3: Akkumulator
- 4: erster Akkumulator
- 5: erstes Fahrzeugbordnetz
- 6: zweites Fahrzeugbordnetz
- 7: DC/DC-Wandler
- 8: Steuereinrichtung
- 9: Testsignalmodul
- 10: Testsignal
- 11: Messwerterfassungsmodul
- 12: Auswertemodul
- 13: Spannungssprunggebermodul
- 14: Strommessermodul
- 15: Stromsprunggebermodul
- 16: Spannungsmessermodul
- 17: Spannungsimpulsgebermodul
- 18: Stromimpulsgebermodul
- 19: Wechselspannungsgebermodul
- 20: Wechselstromgebermodul
- 21: Anzeigemodul
- 22: optische Anzeige
- 23: Warnmodul
- 24: akustische Anzeige
- 25: Bleiakkumulator
- 26: Litiumionenakkumulator
- 27: AC/DC-Wandler
- 28: Wechselstromgenerator (dreiphasig)
- 29: BUS-Leitung
- 30: Aufladevorrichtung
- 31: Verbraucher
- 32: Beleuchtungskörper
- 33: induktive Wicklungen
- 34: Heizwiderstand
- 35: Verbindungsleitung
- 36: Leitung
- 37: Leitung
- 38: Verbraucher

- A: Ausgang
- E: Eingang
- U_{H}: hohe Betriebsspannung
- U_{N}: niedrige Betriebsspannung
- U_{HE}: hohe Eingangsspannung
- U_{NA}: niedrige Ausgangsspannung
- U_{HL}: hohe Ladegleichspannung
- U_{NL}: niedrige Ladegleichspannung
- uᵣ(t): Spannungsverlauf
- iᵣ(t): Stromverlauf

## Patentansprüche

1. Vorrichtung zur Erfassung des Zustands eines zu prüfenden Akkumulators (3) eines Fahrzeugs mit mindestens zwei Fahrzeugbordnetzen (5, 6) unterschiedlicher Betriebsspannungen (U_{H}, U_{N}), aufweisend:
- einen DC/DC-Wandler (7), der eine erste Gleichspannung (U_{H}) eines ersten Fahrzeugbordnetzes (5) in eine zweite Gleichspannung (U_{N}) des Akkumulators (3) des zweiten Fahrzeugbordnetzes (6) wandelt;
- eine Steuereinrichtung (8) der Fahrzeugbordnetze (5, 6),
wobei die Steuereinrichtung (8) der Fahrzeugbordnetze (5, 6) zusätzlich aufweist:
- ein Testsignalmodul (9), das eingerichtet ist, ein Testsignal (10) über den DC/DC-Wandler (7) an den zu prüfenden Akkumulator (3) anzulegen,
wobei die Vorrichtung ist **gekennzeichnet durch**
- ein Messwerterfassungsmodul (11), das eingerichtet ist, die Reaktionswerte als zeitlichen Verlauf des Stromes oder der Spannung des zu prüfenden Akkumulators (3) zu messen und
- ein Auswertemodul (12), das eingerichtet ist, aus dem zeitlichen Verlauf der Reaktionswerte den Zustand des Akkumulators (3) zu erfassen.

2. Vorrichtung nach Anspruch 1, wobei das Testsignalmodul (9) ein Spannungssprunggebermodul (13) aufweist und das Messwerterfassungsmodul (11) ein Strommessermodul (14) aufweist, das den zeitlichen Verlauf des Stromes (iᵣ(t)) als Reaktion des Akkumulators (3) erfasst.

3. Vorrichtung nach Anspruch 1, wobei das Testsignalmodul (9) ein Stromsprunggebermodul (15) aufweist und das Messwerterfassungsmodul (11) ein Spannungsmessermodul (16) aufweist, das den zeitlichen Verlauf der Spannung (uᵣ(t)) als Reaktion des Akkumulators (3) erfasst.

4. Vorrichtung nach Anspruch 1, wobei das Testsignalmodul (9) ein Spannungsimpulsgebermodul (17) aufweist und das Messwerterfassungsmodul (11) ein Strommessermodul (14) aufweist, das den zeitlichen Verlauf des Stromes (iᵣ(t)) als Reaktion des Akkumulators (3) erfasst.

5. Vorrichtung nach Anspruch 1, wobei das Testsignalmodul (9) ein Stromimpulsgebermodul (18) aufweist und das Messwerterfassungsmodul (11) ein Spannungsmessermodul (16) aufweist, das den zeitlichen Verlauf der Spannung (uᵣ(t)) als Reaktion des Akkumulators (3) erfasst.

6. Vorrichtung nach Anspruch 1, wobei das Testsignalmodul (9) ein Wechselspannungsgebermodul (19) aufweist und das Messwerterfassungsmodul (11) ein Strommessermodul (14) aufweist, das den Verlauf des Stromes (iᵣ(t)) als Reaktion des Akkumulators (3) erfasst.

7. Vorrichtung nach Anspruch 1, wobei das Testsignalmodul (9) ein Wechselstromgebermodul (20) aufweist und das Messwerterfassungsmodul (11) ein Spannungsmessermodul (16) aufweist, das den zeitlichen Verlauf der Spannung (uᵣ(t)) als Reaktion des Akkumulators (3) erfasst.

8. Vorrichtung nach einem der vorhergehenden Ansprüche, wobei das Auswertemodul (12) mit einem Anzeigemodul (21) zusammenwirkt, wobei das Anzeigemodul (21) eine optische Anzeige (22) für einen Ladezustand anzeigt.

9. Vorrichtung nach einem der vorhergehenden Ansprüche, wobei das Auswertemodul (12) mit einem Anzeigemodul (21) zusammenwirkt, und wobei das Anzeigemodul (21) eine optische Anzeige für einen SOH-Zustand anzeigt.

10. Vorrichtung nach einem der vorhergehenden Ansprüche, wobei die Vorrichtung ein Warnmodul (23) aufweist, das mittels der optischen und/oder einer akustischen Anzeige (22, 24) bei einem kritischen Ladezustand und/oder einem kritischen SOH-Zustand ein Warnzeichen und/oder ein Warnsignal generiert.

## Claims

1. Apparatus for detecting the state of a rechargeable battery (3) to be checked in a vehicle having at least two vehicle onboard power supply systems (5, 6) having different operating voltages (U_{H}, U_{N}), comprising:
- a DC/DC converter (7), which converts a first DC voltage (U_{H}) of a first vehicle onboard power supply system (5) into a second DC voltage (U_{N}) of the rechargeable battery (3) of the second vehicle onboard power supply system (6);
- a control device (8) of the vehicle onboard power supply systems (5, 6),
wherein the control device (8) of the vehicle onboard power supply systems (5, 6) additionally comprises:
- a test signal module (9) set up for applying a test signal (10) to the rechargeable battery (3) to be checked via the DC/DC converter (7),
wherein the apparatus is **characterized by**
- a measured value detection module (11) set up for measuring the reaction values as temporal profile of the current or of the voltage of the rechargeable battery (3) to be checked, and
- an evaluation module (12) set up for detecting the state of the rechargeable battery (3) from the temporal profile of the reaction values.

2. Apparatus according to Claim 1, wherein the test signal module (9) comprises a voltage jump transmitter module (13) and the measured value detection module (11) comprises an ammeter module (14), which detects the temporal profile of the current (iᵣ(t)) as a reaction of the rechargeable battery (3).

3. Apparatus according to Claim 1, wherein the test signal module (9) comprises a current jump transmitter module (15) and the measured value detection module (11) comprises a voltmeter module (16), which detects the temporal profile of the voltage (uᵣ(t)) as a reaction of the rechargeable battery (3).

4. Apparatus according to Claim 1, wherein the test signal module (9) comprises a voltage pulse transmitter module (17) and the measured value detection module (11) comprises an ammeter module (14), which detects the temporal profile of the current (iᵣ(t)) as a reaction of the rechargeable battery (3).

5. Apparatus according to Claim 1, wherein the test signal module (9) comprises a current pulse transmitter module (18) and the measured value detection module (11) comprises a voltmeter module (16), which detects the temporal profile of the voltage (uᵣ(t)) as a reaction of the rechargeable battery (3) .

6. Apparatus according to Claim 1, wherein the test signal module (9) comprises an AC voltage transmitter module (19) and the measured value detection module (11) comprises an ammeter module (14), which detects the profile of the current (iᵣ(t)) as a reaction of the rechargeable battery (3).

7. Apparatus according to Claim 1, wherein the test signal module (9) comprises an AC current transmitter module (20) and the measured value detection module (11) comprises a voltmeter module (16), which detects the temporal profile of the voltage (uᵣ(t)) as a reaction of the rechargeable battery (3).

8. Apparatus according to any of the preceding claims, wherein the evaluation module (12) co-operates with an indicator module (21), wherein the indicator module (21) indicates an optical indicator (22) for a state of charge.

9. Apparatus according to any of the preceding claims, wherein the evaluation module (12) co-operates with an indicator module (21), and wherein the indicator module (21) indicates an optical indicator for an SOH state.

10. Apparatus according to any of the preceding claims, wherein the apparatus comprises a warning module (23), which generates a warning sign and/or a warning signal by means of the optical and/or an acoustic indicator (22, 24) in the case of a critical state of charge and/or a critical SOH state.

## Revendications

1. Dispositif de détection de l'état d'un accumulateur (3) à tester d'un véhicule, comportant au moins deux réseaux de bord de véhicule (5, 6) ayant des tensions de fonctionnement différentes (U_{H}, U_{N}), comportant :
- un convertisseur continu/continu (7) qui convertit une première tension continue (U_{H}) d'un premier réseau de bord de véhicule (5) en une seconde tension continue (U_{N}) de l'accumulateur (3) du second réseau de bord de véhicule (6) ;
- un dispositif de commande (8) des réseaux de bord de véhicule (5, 6),
dans lequel le dispositif de commande (8) des réseaux de bord de véhicule (5, 6) comprend en outre :
- un module de signal de test (9) qui est conçu pour appliquer un signal de test (10) par l'intermédiaire du convertisseur continu/continu (7) à l'accumulateur (3) à tester,
dans lequel le dispositif est **caractérisé par**
- un module d'acquisition de valeurs de mesure (11) qui est conçu pour mesurer les valeurs de réaction sous la forme d'une courbe temporelle du courant ou de la tension de l'accumulateur (3) à tester et
- un module d'évaluation (12) qui est conçu pour détecter l'état de l'accumulateur (3) à partir de la courbe temporelle des valeurs de réaction.

2. Dispositif selon la revendication 1, dans lequel le module de signal de test (9) comprend un module générateur de saut de tension (13) et le module de détection de valeurs de mesure (11) comprend un module de mesure de courant (14) qui détecte la courbe temporelle du courant (iᵣ(t)) en tant que réaction de l'accumulateur (3).

3. Dispositif selon la revendication 1, dans lequel le module de signal de test (9) comprend un module générateur de saut de courant (15) et le module de détection de valeurs de mesure (11) comprend un module de mesure de tension (16) qui détecte la courbe temporelle de la tension (uᵣ(t)) en tant que réaction de l'accumulateur (3).

4. Dispositif selon la revendication 1, dans lequel le module de signal de test (9) comprend un module générateur d'impulsions de tension (17) et le module de détection de valeurs de mesure (11) comprend un module de mesure de courant (14) qui détecte la courbe temporelle du courant (iᵣ(t)) en tant que réaction de l'accumulateur (3).

5. Dispositif selon la revendication 1, dans lequel le module de signal de test (9) comprend un module générateur d'impulsions de courant (18) et le module de détection de valeurs de mesure (11) comprend un module de mesure de tension (16) qui détecte la courbe temporelle de la tension (uᵣ(t)) en tant que réaction de l'accumulateur (3).

6. Dispositif selon la revendication 1, dans lequel le module de signal de test (9) comprend un module générateur de tension alternative (19) et le module de détection de valeurs de mesure (11) comprend un module de mesure de courant (14) qui détecte la courbe du courant (iᵣ(t)) en tant que réaction de l'accumulateur (3).

7. Dispositif selon la revendication 1, dans lequel le module de signal de test (9) comprend un module générateur de courant alternatif (20) et le module de détection de valeurs de mesure (11) comprend un module de mesure de tension (16) qui détecte la courbe temporelle de la tension (uᵣ(t)) en tant que réaction de l'accumulateur (3).

8. Dispositif selon l'une quelconque des revendications précédentes, dans lequel le module d'évaluation (12) coopère avec un module d'affichage (21), dans lequel le module d'affichage (21) affiche une indication optique (22) d'un état de charge.

9. Dispositif selon l'une quelconque des revendications précédentes, dans lequel le module d'évaluation (12) coopère avec un module d'affichage (21), et le module d'affichage (21) affiche une indication optique d'un état SOH.

10. Dispositif selon l'une quelconque des revendications précédentes, dans lequel le dispositif comprend un module d'avertissement (23) qui génère un symbole d'avertissement et/ou un signal d'avertissement au moyen de l'affichage optique et/ou acoustique (22, 24) en cas d'état de charge critique et/ou d'état SOH critique.
